# EUROPEAN PATENT SPECIFICATION

(11) **EP 2 759 794 B1**
(45) Date of publication and mention of the grant of the patent: **18.10.2017**
(21) Application number: 13290022.6
(22) Date of filing: 29.01.2013
(51) Int. Cl.: F28D 15/02, H05K 7/20

(54) **Cooling of electronic modules**
Kühlung von elektronischen Modulen
Refroidissement de modules électroniques

(43) Date of publication of application: 30.07.2014
(73) Proprietor: ALCATEL LUCENT, 92100 Boulogne-Billancourt (FR)
(72) Inventor: Goetz, Hans-Joachim, 90411 Nuernberg (DE); Haberditzl, Rainer, 90482 Nuernberg (DE); Seitz, Reinhold, 91161 Hilpoltstein (DE)
(74) Representative: Wetzel, Emmanuelle

(56) References cited:
- US-A1- 2003 192 669
- US-A1- 2010 254 083

## Description

### TECHNICAL FIELD

The present invention relates to the area of cooling of electronic modules placed on circuit boards and, more particularly but not exclusively, to cooling of electronic modules placed on vertically arranged circuit boards.

### BACKGROUND

In use, many electronic modules, for example optoelectronic modules, arranged on circuit boards generate heat which has to be dissipated from the electronic modules to prevent heat damages and to enhance operation characteristics. Therefore, it is known to cool electronic modules by connecting them with one or more cooling devices.

Because the space to place a cooling device on an electronic module is very limited, especially due to a desired narrow arrangement of the connecting elements of an electric assembly, it is sometimes not possible to place a suitable cooling device directly on the heat producing area of an electronic module. Instead, heat produced by an electronic module has to be conducted to a heat sink that is positioned in a suitable distance from the electronic module where more space is available.

US 2010/254083 A1 discloses a heat dissipation device comprising a heat absorbing plate, that is heat-conductively connectable to a heat generating component that is arranged on a printed circuit board, a heat sink, and a heat pipe heat-conductively connecting the heat absorbing plate with the heat sink.

US 2003/0192669 A1 relates to a micro-loop heat pipe comprising a flexible metal film forming a closed space in which a working fluid may circulate, the flexible metal film having a heat-absorbing zone and a heat-dissipating zone.

In some cases, especially when multiple electronic modules are arranged on a circuit board, there isn't enough space to place an individual heat sink on each electronic module. Instead, a common heat sink has to be used that is heat-conductively connected to a corresponding number of heat absorbing elements each heat-conductively connected to the individual electronic modules. In general, such an arrangement formed by a common heat sink and heat absorbing elements is pre-fabricated and is only applicable in special cases because the positions of the heat absorbing elements relative to each other and with respect to the common heat sink cannot be amended to adapt such a cooling arrangement to different arrangements of electronic modules.

Therefore, a cooling solution is desired which allows effective cooling of electronic modules even if the space for a placement of suitable cooling devices is very limited and which can be adapted to different arrangements of electronic modules.

### SUMMARY

Various embodiments provide a cooling device and an electronic module of providing a solution for providing effective cooling of electronic modules.

In a first embodiment, a device is provided for cooling of at least two electronic modules that are arranged on a circuit board, characterized by a common heat dissipating device and at least two heat absorbing bodies, wherein each heat absorbing body is heat-conductively connected to the common heat dissipating device and can be heat-conductively connected to one of the electronic modules, wherein at least one heat absorbing body is heat-conductively connected to the common heat dissipating device via at least one flexible heat pipe, the heat pipe comprising a heat absorbing end section, a heat dissipating end section, and an axial and lateral flexible intermediate section, with the axial and lateral flexible intermediate section being arranged between the heat absorbing end section and the heat dissipating end section.

According to the device of the first embodiment, heat produced by at least two electronic modules can be dissipated from the electronic modules by heat-conductively connecting an individual heat absorbing body to each electronic module. From the heat absorbing bodies heat can be conducted to the common heat dissipating device. For this purpose, the heat absorbing bodies are heat-conductively connected to the common heat dissipating device. At least one heat absorbing body is heat-conductively connected to the common heat dissipating device via at least one axial and lateral flexible heat pipe. The flexible heat pipe comprises a heat absorbing end section, a heat dissipating end section, and an axial and lateral flexible intermediate section, with the axial and lateral flexible intermediate section being arranged between the heat absorbing end section and the heat dissipating end section. Therefore, it is possible to place this heat absorbing body in different positions and orientations with respect to the common heat dissipating device. This allows connecting the common heat dissipating device to differently constructed arrangements of electronic modules and allows compensating typically occurring individual mechanical tolerances.

Therefore, according to the first embodiment, heat produced by an electronic module can be dissipated from the heat dissipating area of an electronic module by a heat absorbing body which can be constructed relative small-sized with respect to a conventional cooling device. Thus, the device according to the first embodiment can be used even when the space to place such a device is very limited. Moreover, the device according to the first embodiment can easily be adapted to different kinds of arrangements of electronic modules. To enhance these adaption characteristics of the cooling device preferably each heat absorbing body is heat-conductively connected to the common heat dissipating device via at least one individual axial and lateral flexible heat pipe.

The device of the first embodiment can be applied to cool at least two electronic modules of the same kind or a different kind.

In general, a heat pipe is a heat-transfer device that combines the principles of both thermal conductivity and phase transition to efficiently manage the transfer of heat between two solid interfaces. At the hot interface within a heat pipe a liquid in contact with a thermally conductive solid surface turns into a vapor by absorbing heat from that surface. The vapor condenses back into a liquid at the cold interface, releasing the latent heat. The liquid then returns to the hot interface through either capillary action or gravity action where it evaporates once more and repeats the cycle. In addition, the internal pressure of the heat pipe can be set or adjusted to facilitate the phase change depending on the demands of the working conditions of the thermally managed system. Therefore, the liquid is condensed in the heat absorbing end section of the flexible heat pipe. The generated vapor condenses back into a liquid in the heat dissipating end section of the heat pipe.

According to a preferred embodiment of the first embodiment the heat absorbing end section is at least partly embedded in the heat absorbing body and/or the heat dissipating end section is at least partly embedded in the common heat dissipating device. This embedding of rigid sections of the flexible heat pipe into the heat absorbing body and/or the common heat dissipating device enhances the heat conductivity of the entire cooling device. Further, mechanical robustness of the entire cooling device is enhanced.

According to a preferred embodiment of the first embodiment, when the heat absorbing body, that is heat-conductively connected to the common heat dissipating device via the at least one flexible heat pipe, is arranged as intended on the respective electronic module, at least one section of the flexible heat pipe is arranged tilted upwards. Preferably the heat dissipating end section and the axial and lateral flexible intermediate section are correspondingly arranged. Through this, liquid being produced by condensed vapor in the heat dissipating section of the flexible heat pipe can return to the hot interface of the heat absorbing end section running at least partly through the heat absorbing body by gravity action.

According to a preferred embodiment of the first embodiment at least one further heat pipe and/or at least one cooling channel is at least partly embedded in the common heat dissipating device. This also enhances the cooling characteristics of the common heat dissipating device and therefore enhances corresponding characteristics of the entire cooling device.

According to a preferred embodiment of the first embodiment the at least one heat absorbing body, that is heat-conductively connected to the common heat dissipating device via the at least one flexible heat pipe, comprises a top section and at least one lateral section, wherein, when the heat absorbing body is arranged on the respective electronic module as intended, the top section being arranged on the top side of the respective electronic module facing away from the circuit board and the lateral section being arranged on a side of said electronic module that is arranged perpendicular to the top side. Preferably, the heat absorbing end section is at least partly embedded in the lateral section. Because the heat absorbing end section of the heat pipe is arranged according to this embodiment on a side of the electronic module the top section of the heat absorbing body can be constructed relative small-sized. This makes it possible to use the cooling device also in cases, where space for arrangement of such a cooling device is very limited, in particular, due to the close arrangement of neighboring circuit boards.

According to a preferred embodiment of the first embodiment the common heat dissipating device and at least one heat absorbing body, when arranged on the circuit board as intended, are arranged on different sides or on the same side of the circuit board. Through this it is possible to adapt the present cooling device to different arrangements of electronic modules.

According to a preferred embodiment of the latest embodiment the common heat dissipating device is arranged on one side of the circuit board and is heat-conductively connected to at least one heat absorbing body arranged on this side of the circuit board and to at least one heat absorbing body arranged on the other side of the circuit board. By this, the cooling device can be also used for cooling so called belly-to-belly devices where electronic modules are arranged on both sides of a circuit board. According to a preferred embodiment of the first embodiment the heat dissipating end section or the heat absorbing end section of at least one heat pipe is angled. This is for example advantageously if the common heat dissipating device is arranged substantially perpendicular to the direction defined by a row of electronic modules.

According to a preferred embodiment of the first embodiment at least one heat absorbing body and/or the common heat dissipating device is at least partly provided with cooling ribs and/or cooling pins. By this, cooling characteristics of the at least one heat absorbing body and/or the common heat dissipating device can be enhanced. Preferably, the cooling ribs extend vertically on the cooling section and/or the cooling pins are arranged in vertical rows on the cooling section. This enables effective cooling of an electronic module because cooling by upstream air convection is enhanced.

In a second embodiment, an electronic device is provided, comprising a circuit board, at least two electronic modules arranged on the circuit board, and at least one device for cooling the electronic modules, wherein the device for cooling the electronic modules is heat-conductively connected to the electronic modules, characterized in that the device is designed according to one of the preceding embodiments or any combination thereof.

According to a preferred embodiment of the second embodiment at least one electronic module is an optoelectronic module, an integrated circuit (e. g. FPGA, ASIC) or an electronic power device. Optoelectronic modules may be constructed in form of pluggable transceivers (e.g. SFP, XFP, CFP).

According to a preferred embodiment of the second embodiment at least one electronic module is pluggable in or fixed to the circuit board.

### BRIEF DESCRIPTION OF THE DRAWINGS

Some embodiments of the device in accordance with the present invention are now described, by way of example only, and with reference to the accompanying drawings, in which:
- Fig. 1a: is a schematic top view showing a first embodiment of a device,
- Fig. 1b: is a schematic side view of a first embodiment of an electronic device comprising the device shown in Fig. 1a,
- Fig. 2a: is a schematic top view showing a second embodiment of a device,
- Fig. 2b: is a schematic side view of a second embodiment of an electronic device comprising the device shown in Fig. 2a,
- Fig. 3a: is a schematic top view showing a third embodiment of a device,
- Fig. 3b: is a schematic side view of a third embodiment of an electronic device comprising the device shown in Fig. 3a,
- Fig. 3c: is a schematic front view of the electronic device shown in Fig. 3b,
- Fig. 4a: is a schematic side view showing a forth embodiment of an electronic device,
- Fig. 4b: is a schematic front view of the electronic device shown in Fig. 4a,
- Fig. 5: is a schematic view of a further embodiment of an electronic device,
- Fig. 6: is a schematic view of a further embodiment of an electronic device,
- Fig. 7a: is a schematic top view showing a part of the first embodiment of the device shown in Fig. 1a,
- Fig. 7b: is a schematic side view of the part shown in Fig. 7a,
- Fig. 8a: is a schematic top view showing a part of a further embodiment of a device, and
- Fig. 8b: is a schematic side view of the embodiment of an electronic device comprising the device shown in Fig. 8a.

### DETAILED DESCRIPTION OF ILLUSTRATIVE EMBODIMENTS

The description and drawings merely illustrate the principles of the invention. Additionally, the term, "or," as used herein, refers to a non-exclusive or, unless otherwise indicated (e.g., "or else" or "or in the alternative"). Also, the various embodiments described herein are not necessarily mutually exclusive, as some embodiments can be combined with one or more other embodiments to form new embodiments.

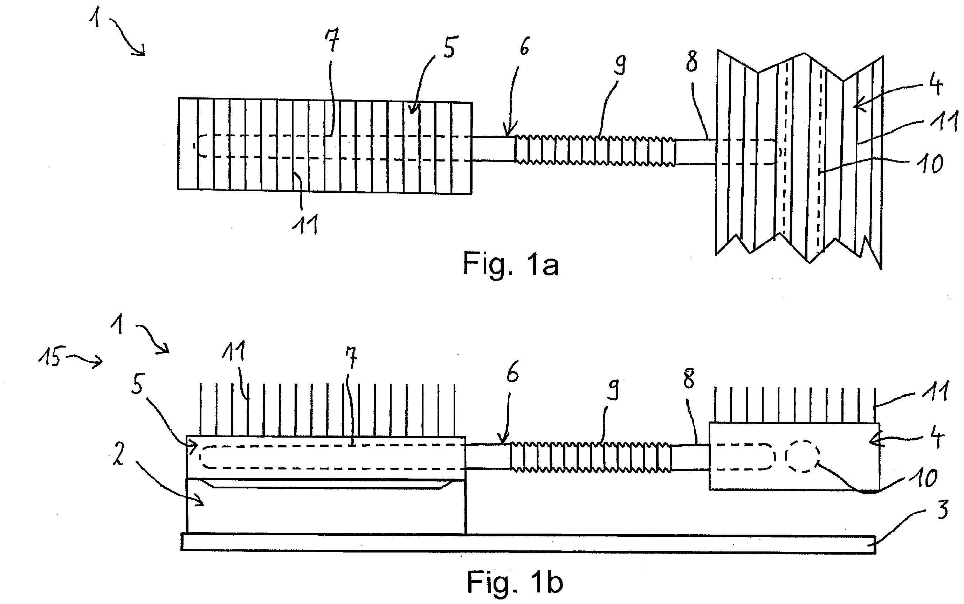

Figure 1a schematically shows a top view of a device 1 for cooling of at least two electronic modules 2 (not shown) that are arranged on a circuit board 3 (not shown), the circuit board 3 and one of the electronic modules 2 are shown in figure 1b.

The device 1 comprises a common heat dissipating device 4 and at least two heat absorbing bodies 5 (only one is shown). The heat absorbing body 5 is heat-conductively connected to the electronic module 2. The heat absorbing body 5 is heat-conductively connected to the common heat dissipating device 4 via a flexible heat pipe 6. The flexible heat pipe 6 comprises a heat absorbing end section 7, a heat dissipating end section 8, and an axial and lateral flexible intermediate section 9, with the axial and lateral flexible intermediate section 9 being arranged between the heat absorbing end section 7 and the heat dissipating end section 8.

The heat absorbing end section 7 of the heat pipe 6 is partly embedded in the heat absorbing body 5 and the heat dissipating end section 8 of the heat pipe 6 is partly embedded in the common heat dissipating device 4. One further heat pipe 10 is embedded in the common heat dissipating device 4. The heat absorbing body 5 and the common heat dissipating device 4 are provided with cooling ribs 11 on their top surfaces.

Figure 1b is a schematic side view of a first embodiment of an electronic device 15 comprising the device 1 shown in figure 1a. The heat absorbing body 5 is heat-conductively connected to the electronic module 2 which is arranged on the circuit board 3.

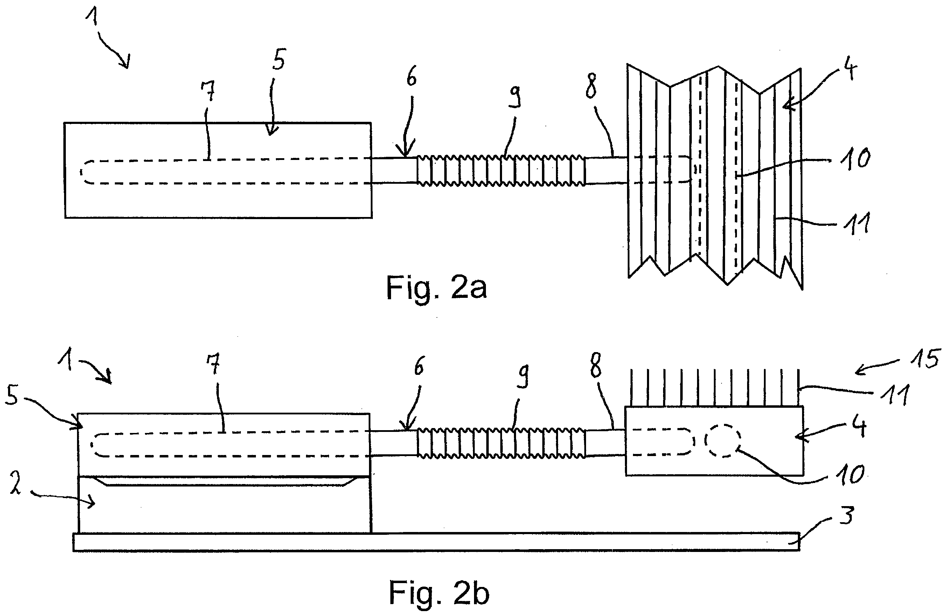

Figure 2a is a schematic top view showing a second embodiment of a device 1. This embodiment differs from that shown in figures 1a and 1b in that no cooling ribs 11 are provided on the heat absorbing body 5.

Figure 2b is a schematic side view of a second embodiment of an electronic device 15 comprising the device 1 shown in figure 2a.

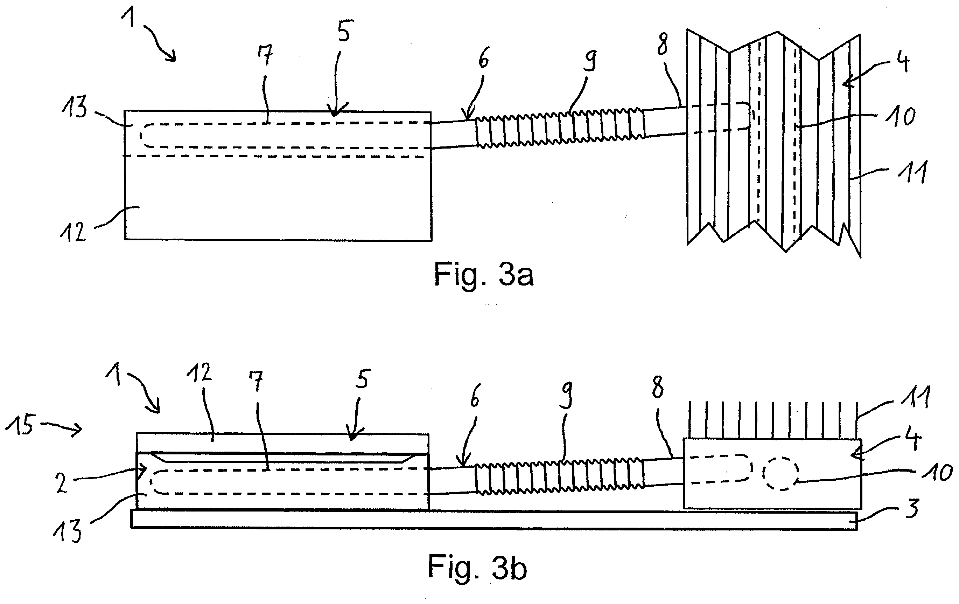

Figures 3a shows a schematic top view of a third embodiment of a device 1. The heat absorbing body 5 that is heat-conductively connected to the common heat dissipating device 4 via the flexible heat pipe 6 comprises a top section 12 and a lateral section 13. The heat absorbing body 5 is arranged as intended on a respective electronic module 2 (not shown), wherein i. a. the flexible intermediate section 9 and the heat dissipating end section 8 of the flexible heat pipe 6 are arranged tilted upwards starting from the heat absorbing body 5.

Figure 3b is a schematic side view of a third embodiment of an electronic device 15 comprising the device 1 shown in figure 3a. In particular, figure 3b shows the intended arrangement of the heat absorbing body 5 on the respective electronic module 2, wherein the top section 12 being arranged on the top side of the electronic module 2 facing away from the circuit board 3 and the lateral section 13 being arranged on a side of said electronic module 2 that is arranged perpendicular to the top side.

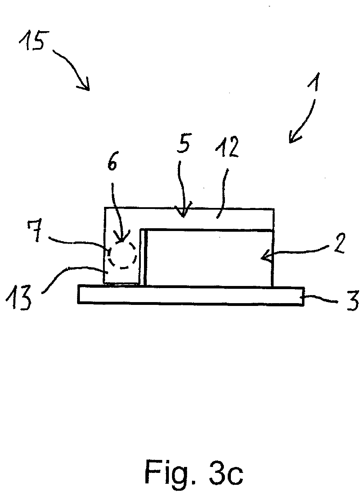

Figure 3c is a schematic front view of the electronic device 15 shown in figure 3b. Figures 3a and 3c show that the heat absorbing end section 7 of the heat pipe 6 is partly embedded in the lateral section 13 of the heat absorbing body 5.

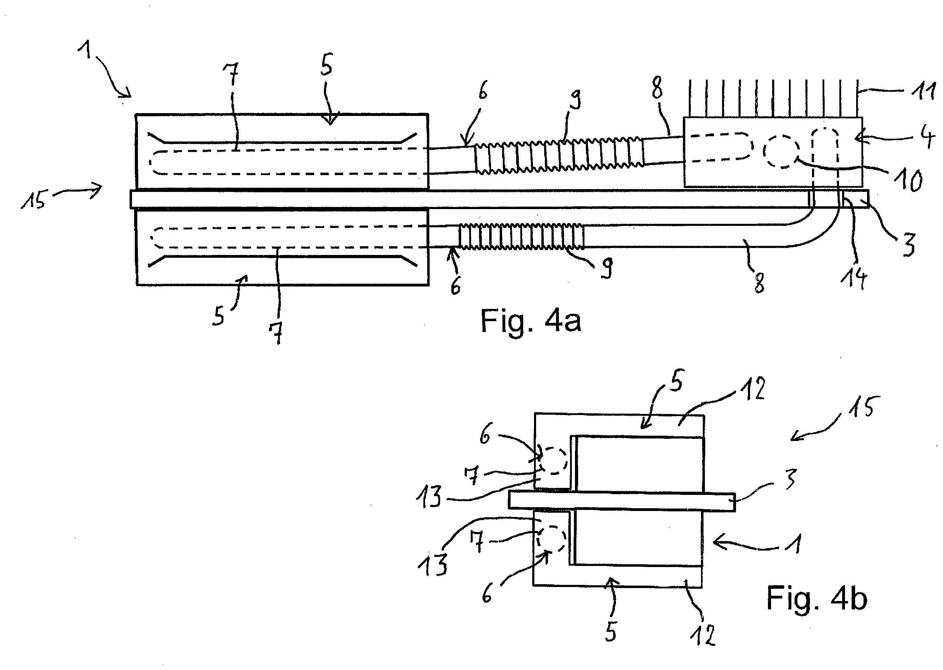

Figure 4a is a schematic side view showing a forth embodiment of an electronic device 15. Two heat absorbing bodies 5 are arranged as intended on the circuit board 3 and are heat-conductively connected to the common heat dissipating device 4. One heat absorbing body 5, i. e. in figure 4a the lower heat absorbing body 5, and the heat dissipating device 4 are arranged on opposite sides of the circuit board 3. The other heat absorbing body 5, i. e. in figure 4a the upper heat absorbing body 5, is arranged on the same side of the circuit board 3 as the common heat dissipating device 4. The heat absorbing bodies 5 are constructed according to the third embodiment of the device shown in figure 3a. The heat pipe 6 connecting the lower heat absorbing body 5 with the common heat dissipating device 4 has an angled heat dissipating end section 8 extending through an opening 14 in the circuit board 3. The common heat dissipating device 4 is provided with cooling ribs 11.

Figure 4b is a schematic front view of the electronic device 15 shown in figure 4a.

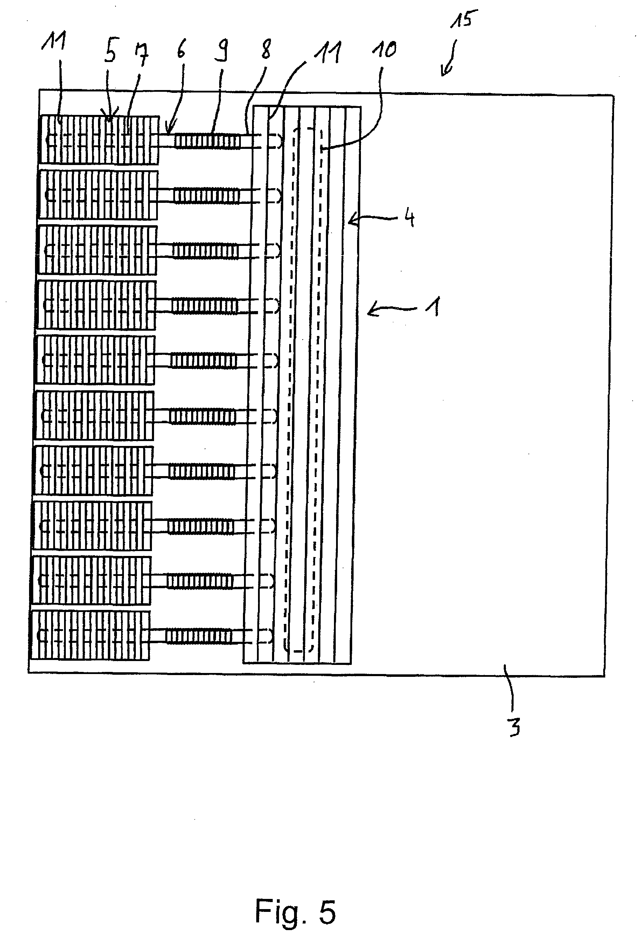

Figure 5 is a schematic view of a further embodiment of an electronic device 15. The electronic device 15 comprises a vertically arranged circuit board 3, ten electronic modules 2 (not shown) arranged on the circuit board 3, and one device 1 for cooling the electronic modules 2. The device 1 for cooling the electronic modules 2 is heat-conductively connected to the electronic modules 2 via ten heat absorbing bodies 5. Each heat absorbing body 5 is heat-conductively connected to the common heat dissipating device 4 via an individual lateral and axial flexible heat pipe 6. The device 1 is constructed according to the first embodiment shown in figure 1a.

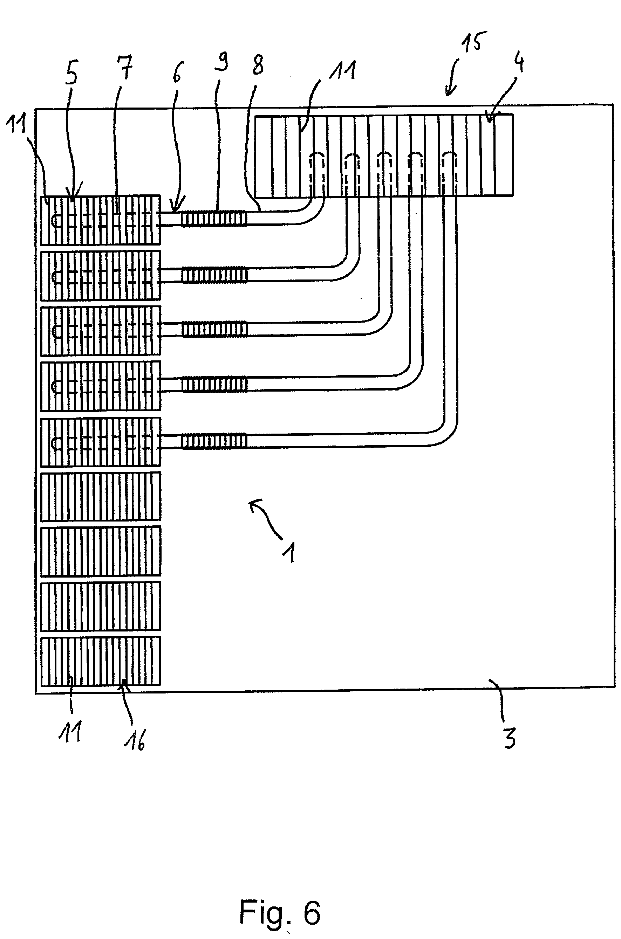

Figure 6 is a schematic view of a further embodiment of an electronic device 15. The electronic device 15 comprises a vertically arranged circuit board 3, nine electronic modules 2 (not shown) arranged on the circuit board 3, and one device 1 for cooling the electronic modules 2. The device 1 for cooling the electronic modules 2 is heat-conductively connected to the electronic modules 2 via five heat absorbing bodies 5. Each heat absorbing body 5 is heat-conductively connected to the common heat dissipating device 4 via an individual lateral and axial flexible heat pipe 6. The four lower electronic modules 2 (not shown) each are heat-conductively connected to an individual passive heat dissipating body 16 with cooling ribs 11. The heat dissipating end sections 8 of the heat pipes 6 of the device 1 are angled.

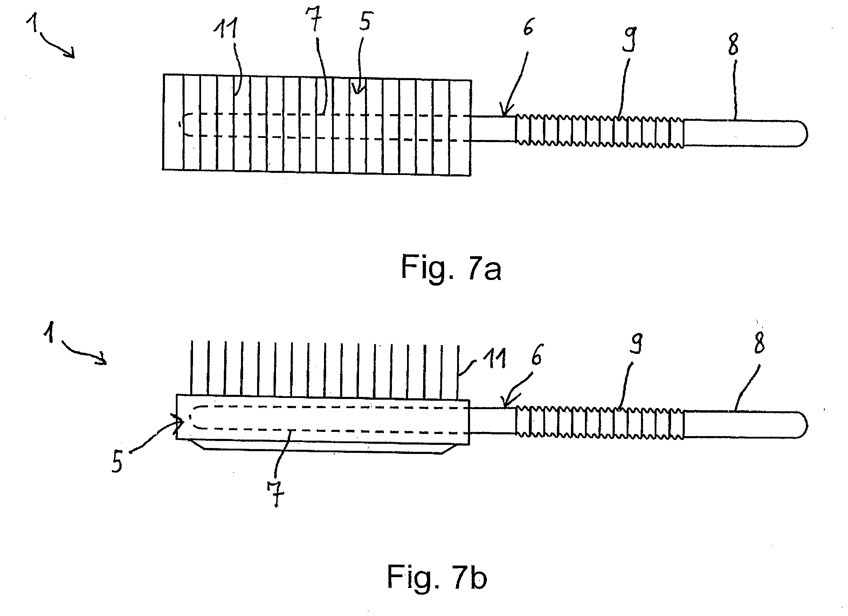

Figure 7a is a schematic top view showing a part of the first embodiment of the device 1 shown in Fig. 1a. Figure 7b is a schematic side view of the part shown in Fig. 7a. The part of the device 1 shown in figures 7a and 7b can be a mass production part that can be combined with a common heat dissipating device 4 as shown i. a. in Figure 1a.

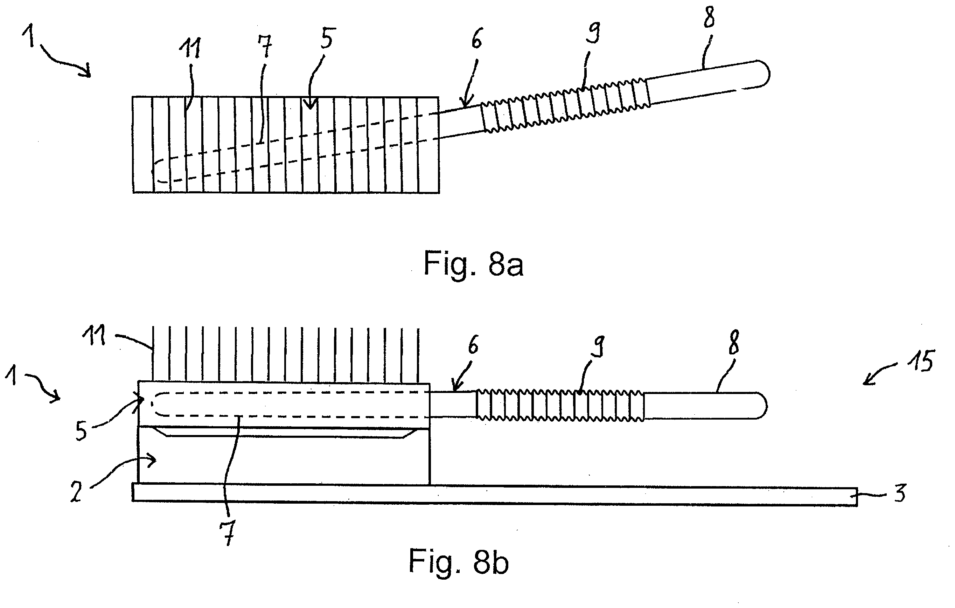

Figure 8a is a schematic top view showing a part of a further embodiment of a device 1. The part shown in figure 8a differs from the part shown in figures 7a and 7b in that the flexible heat pipe 6 is arranged tilted upwards when the part shown in figure 8a is arranged on a vertical arranged circuit board 3. Through this, the efficiency of the heat pipe 6 is improved when it is arranged tilted upwards.

Figure 8b is a schematic side view of the embodiment of an electronic device 15 comprising the device 1 shown in figure 8a.

In figures 1a to 3b, 4a and 5 to 8b the cooling ribs 11 are arranged in such a way on the heat absorbing body 5 and/or on the common heat dissipating device 4 that the best cooling characteristics are achieved when arranged on a circuit board 3 that is vertically arranged as, for example, is shown in figures 5 and 6. If the circuit board 3 is not vertically arranged the orientation of the cooling ribs 11 has to be amended, in particular, to allow convective air flow for dissipating heat from the common heat dissipating device and/or the heat absorbing body 5.

## Claims

1. A device (1) for cooling of at least two electronic modules (2) that are arranged on a circuit board (3),
**characterized by**
a common heat dissipating device (4) and at least two heat absorbing bodies (5), wherein each heat absorbing body (5) is heat-conductively connected to the common heat dissipating device (4) and can be heat-conductively connected to one of the electronic modules (2), wherein at least one heat absorbing body (5) is heat-conductively connected to the common heat dissipating device (4) via at least one flexible heat pipe (6), the heat pipe (6) comprising a heat absorbing end section (7), a heat dissipating end section (8), and an axial and lateral flexible intermediate section (9), with the axial and lateral flexible intermediate section (9) being arranged between the heat absorbing end section (7) and the heat dissipating end section (8).

2. The device (1) according to claim 1,
**characterized in that**
the heat absorbing end section (7) is at least partly embedded in the heat absorbing body (5) and/or the heat dissipating end section (8) is at least partly embedded in the common heat dissipating device (4).

3. The device (1) according to claim 1 or 2,
**characterized in that**,
when the heat absorbing body (5), that is heat-conductively connected to the common heat dissipating device (4) via the at least one flexible heat pipe (6), is arranged as intended on the respective electronic module (2), at least one section (7, 8, 9) of the flexible heat pipe (6) is arranged tilted upwards.

4. The device (1) according to one of the preceding claims,
**characterized in that**
at least one further heat pipe (10) and/or at least one cooling channel is at least partly embedded in the common heat dissipating device (4).

5. The device (1) according to one of the preceding claims,
**characterized in that**,
the at least one heat absorbing body (5), that is heat-conductively connected to the common heat dissipating device (4) via the at least one flexible heat pipe (6), comprises a top section (12) and at least one lateral section (13), wherein, when the heat absorbing body (5) is arranged on the respective electronic module (2) as intended, the top section (12) being arranged on the top side of the respective electronic module (2) facing away from the circuit board (3) and the lateral section (13) being arranged on a side of said electronic module (2) that is arranged perpendicular to the top side.

6. The device (1) according to one of the preceding claims,
**characterized in that**
the common heat dissipating device (4) and at least one heat absorbing body (5), when arranged on the circuit board (3) as intended, are arranged on different sides or on the same side of the circuit board (3).

7. The device (1) according to claim 6,
**characterized in that**
the common heat dissipating device (4) is arranged on one side of the circuit board (3) and is heat-conductively connected to at least one heat absorbing body (5) arranged on this side of the circuit board (3) and to at least one heat absorbing body (5) arranged on the other side of the circuit board (3).

8. The device (1) according to one of the preceding claims,
**characterized in that**
the heat dissipating end section (8) or the heat absorbing end section (7) of at least one flexible heat pipe (6) is angled.

9. The device (1) according to one of the preceding claims,
**characterized in that**
at least one heat absorbing body (5) and/or the common heat dissipating device (4) is at least partly provided with cooling ribs (11) and/or cooling pins.

10. An electronic device (15), comprising a circuit board (3), at least two electronic modules (2) arranged on the circuit board (3), and at least one device (1) for cooling the electronic modules (2), wherein the device (1) for cooling the electronic modules (2) is heat-conductively connected to the electronic modules (2),
**characterized in that**
the device (1) is designed according to one of the preceding claims.

11. The electronic device (15) according to claim 10,
**characterized in that**
at least one electronic module (2) is an optoelectronic module, an integrated circuit or an electronic power device.

12. The electronic device (15) according to claim 10 or 11,
**characterized in that**
at least one electronic module (2) is pluggable in or fixed to the circuit board (3).

## Patentansprüche

1. Vorrichtung (1) zum Kühlen von mindestens zwei elektronischen Modulen (2), die auf einer Leiterplatte (3) angeordnet sind,
**gekennzeichnet durch**
eine gemeinsame Wärmeableitvorrichtung (4) und mindestens zwei wärmeabsorbierende Körper (5), wobei jeder wärmeabsorbierende Körper (5) wärmeleitend mit der Wärmeableitvorrichtung (4) verbunden ist und wärmeleitend mit einem der elektronischen Module (2) verbunden sein kann, wobei mindestens ein wärmeabsorbierender Körper (5) wärmeleitend verbunden ist mit der gemeinsamen Wärmeableitvorrichtung (4) über mindestens ein flexibles Wärmerohr (6), wobei das Wärmerohr (6) einen wärmeabsorbierenden Endabschnitt (7), einen wärmeableitenden Endabschnitt (8) und einen axial und lateral flexiblen Zwischenabschnitt (9) umfasst und wobei der axial und lateral flexible Zwischenabschnitt (9) zwischen dem wärmeabsorbierenden Endabschnitt (7) und dem wärmeableitenden Endabschnitt (8) angeordnet ist.

2. Vorrichtung (1) nach Anspruch 1,
**dadurch gekennzeichnet, dass**
der wärmeabsorbierende Endabschnitt (7) mindestens teilweise in den wärmeabsorbierenden Körper (5) eingebettet ist und/oder der wärmeableitende Endabschnitt (8) mindestens teilweise in die gemeinsam Wärmeableitvorrichtung (4) eingebettet ist.

3. Vorrichtung (1) nach Anspruch 1 oder 2,
**dadurch gekennzeichnet, dass**
wenn der wärmeabsorbierende Körper (5), der wärmeleitend verbunden ist mit der gemeinsamen Wärmeableitvorrichtung (4) über mindestens ein flexibles Wärmerohr (6), wie vorgesehen auf dem jeweiligen elektronischen Modul (2) angeordnet ist, mindestens ein Abschnitt (7, 8, 9) des flexiblen Wärmerohrs (6) nach oben geneigt angeordnet ist.

4. Vorrichtung (1) nach einem der vorstehenden Ansprüche,
**dadurch gekennzeichnet, dass**
mindestens ein weiteres Wärmerohr (10) und/oder mindestens ein Kühlkanal mindestens teilweise in eine gemeinsame Wärmeableitvorrichtung (4) eingebettet sind.

5. Vorrichtung (1) nach einem der vorstehenden Ansprüche,
**dadurch gekennzeichnet, dass**
mindestens ein wärmeabsorbierender Körper (5), der wärmeleitend mit der gemeinsamen Wärmeableitvorrichtung (4) über mindestens ein flexibles Wärmerohr (6) verbunden ist, einen oberen Abschnitt (12) und mindestens einen lateralen Abschnitt (13) umfasst, wobei, wenn der wärmeabsorbierende Körper (5) wie vorgesehen auf dem jeweiligen elektronischen Modul (2) angeordnet ist, der obere Abschnitt (12) angeordnet ist auf der Oberseite des jeweiligen elektronischen Moduls (2) abgewandt von der Leiterplatte (3) und der laterale Abschnitt (13) angeordnet ist auf einer Seite des besagten elektronischen Moduls (2), das senkrecht zur Oberseite angeordnet ist.

6. Vorrichtung (1) nach einem der vorstehenden Ansprüche,
**dadurch gekennzeichnet, dass**
die gemeinsame Wärmeableitvorrichtung (4) und mindestens ein wärmeabsorbierender Körper (5), wenn wie vorgesehen auf der Leiterplatte (3) angeordnet, auf verschiedenen Seiten oder auf der gleichen Seite der Leiterplatte (3) angeordnet sind.

7. Vorrichtung (1) nach Anspruch 6,
**dadurch gekennzeichnet, dass**
die gemeinsame Wärmeableitvorrichtung (4) auf einer Seite der Leiterplatte (3) angeordnet und wärmeleitend verbunden ist mit mindestens einem wärmeabsorbierenden Körper (5), angeordnet auf dieser Seite der Leiterplatte (3), und mit mindestens einem wärmeabsorbierenden Körper (5), angeordnet auf der anderen Seite der Leiterplatte (3).

8. Vorrichtung (1) nach einem der vorstehenden Ansprüche,
**dadurch gekennzeichnet, dass**
der wärmeableitende Endabschnitt (8) oder der wärmeabsorbierende Endabschnitt (7) von mindestens einem flexiblen Wärmerohr (6) gewinkelt ist.

9. Vorrichtung (1) nach einem der vorstehenden Ansprüche,
**dadurch gekennzeichnet, dass**
mindestens ein wärmeabsorbierender Körper (5) und/oder die gemeinsame Wärmeableitvorrichtung (4) mindestens teilweise versehen sind mit Kühlrippen (11) oder Kühlstiften.

10. Elektronische Vorrichtung (15), umfassend eine Leiterplatte (3), mindestens zwei elektronische Module (2), angeordnet auf der Leiterplatte (3), und mindestens eine Vorrichtung (1) zum Kühlen der elektronischen Module (2), wobei die Vorrichtung (1) zum Kühlen der elektronischen Module (2) wärmeleitend mit den elektronischen Modulen (2) verbunden ist,
**dadurch gekennzeichnet, dass**
die Vorrichtung (1) nach einem der vorstehenden Ansprüche entwickelt ist.

11. Elektronische Vorrichtung (15) nach Anspruch 10,
**dadurch gekennzeichnet, dass**
mindestens ein elektronisches Modul (2) ein optoelektronisches Modul, ein integrierter Schaltkreis oder eine elektronische Leistungsvorrichtung ist.

12. Elektronische Vorrichtung (15) nach Anspruch 10 oder 11,
**dadurch gekennzeichnet, dass**
mindestens ein elektronisches Modul (2) in die Leiterplatte (3) steckbar oder darauf befestigt ist.

## Revendications

1. Dispositif (1) de refroidissement d'au moins deux modules électroniques (2) qui sont disposés sur une carte de circuit imprimé (3),
**caractérisé par**
un dispositif de dissipation de chaleur commun (4) et au moins deux corps absorbant la chaleur (5), dans lequel chaque corps absorbant la chaleur (5) est relié en conduction thermique au dispositif de dissipation de chaleur commun (4) et peut être relié en conduction thermique à un des modules électroniques (2), dans lequel au moins un corps absorbant la chaleur (5) est relié en conduction thermique au dispositif de dissipation de chaleur commun (4) par l'intermédiaire d'au moins un caloduc flexible (6), le caloduc (6) comprenant une section d'extrémité absorbant la chaleur (7), une section d'extrémité dissipant la chaleur (8), et une section intermédiaire flexible axiale et latérale (9), la section intermédiaire flexible axiale et latérale (9) étant disposée entre la section d'extrémité absorbant la chaleur (7) et la section d'extrémité dissipant la chaleur (8).

2. Dispositif (1) selon la revendication 1,
**caractérisé en ce que**
la section d'extrémité absorbant la chaleur (7) est au moins partiellement intégrée dans le corps absorbant la chaleur (5) et/ou la section d'extrémité dissipant la chaleur (8) est au moins partiellement intégrée dans le dispositif de dissipation de chaleur commun (4).

3. Dispositif (1) selon la revendication 1 ou 2,
**caractérisé en ce que**,
lorsque le corps absorbant la chaleur (5), qui est relié en conduction thermique au dispositif de dissipation de chaleur commun (4) par l'intermédiaire de l'au moins un caloduc flexible (6), est disposé comme prévu sur le module électronique respectif (2), au moins une section (7, 8, 9) du caloduc flexible (6) est inclinée vers le haut.

4. Dispositif (1) selon l'une des revendications précédentes,
**caractérisé en ce que**
au moins un autre caloduc (10) et/ou au moins un canal de refroidissement est/sont au moins partiellement intégré(s) dans le dispositif de dissipation de chaleur commun (4).

5. Dispositif (1) selon l'une des revendications précédentes,
**caractérisé en ce que**,
l'au moins un corps absorbant la chaleur (5), qui est relié en conduction thermique au dispositif de dissipation de chaleur commun (4) par l'intermédiaire de l'au moins un caloduc flexible (6), comprend une section supérieure (12) et au moins une section latérale (13), dans lequel, lorsque le corps absorbant la chaleur (5) est disposé sur le module électronique respectif (2) comme prévu, la section supérieure (12) disposée sur le côté supérieur du module électronique respectif (2) opposé à la carte de circuit imprimé (3) et la section latérale (13) étant disposée sur un côté dudit module électronique (2) qui est disposé perpendiculairement au côté supérieur.

6. Dispositif (1) selon l'une des revendications précédentes,
**caractérisé en ce que**
le dispositif de dissipation de chaleur commun (4) et au moins un corps absorbant la chaleur (5), lorsqu'ils sont disposés sur la carte de circuit imprimé (3) comme prévu, sont disposés sur des côtés différents ou sur le même côté de la carte de circuit imprimé (3).

7. Dispositif (1) selon la revendication 6,
**caractérisé en ce que**
le dispositif de dissipation de chaleur commun (4) est disposé sur un côté de la carte de circuit imprimé (3) et est relié en conduction thermique à au moins un corps absorbant la chaleur (5) disposé sur ce côté de la carte de circuit imprimé (3) et à au moins un corps absorbant la chaleur (5) disposé sur l'autre côté de la carte de circuit imprimé (3).

8. Dispositif (1) selon l'une des revendications précédentes,
**caractérisé en ce que**
la section d'extrémité dissipant la chaleur (8) ou la section d'extrémité absorbant la chaleur (7) d'au moins un caloduc flexible (6) est inclinée.

9. Dispositif (1) selon l'une des revendications précédentes,
**caractérisé en ce que**
au moins un corps absorbant la chaleur (5) et/ou le dispositif de dissipation de chaleur commun (4) est/sont au moins partiellement doté(s) d'ailettes de refroidissement (11) et/ou de broches de refroidissement.

10. Dispositif électronique (15), comprenant une carte de circuit imprimé (3), au moins deux modules électroniques (2) disposés sur la carte de circuit imprimé (3), et au moins un dispositif (1) de refroidissement des modules électroniques (2), dans lequel le dispositif (1) de refroidissement des modules électroniques (2) est relié en conduction thermique aux modules électroniques (2),
**caractérisé en ce que**
le dispositif (1) est conçu selon l'une des revendications précédentes.

11. Dispositif électronique (15) selon la revendication 10,
**caractérisé en ce qu'**au moins un module électronique (2) est un module optoélectronique, un circuit intégré ou un dispositif électronique de puissance.

12. Dispositif électronique (15) selon la revendication 10 ou 11,
**caractérisé en ce que**
au moins un module électronique (2) peut être branché dans la carte de circuit imprimé (3) ou est fixé à cette dernière.
